(19) Europäisches Patentamt / European Patent Office / Office européen des brevets

(11) **EP 4 538 724 B1**

(12) **EUROPEAN PATENT SPECIFICATION**

(45) Date of publication and mention
of the grant of the patent:
**05.08.2026 Bulletin 2026/32**

(21) Application number: **23202515.5**

(22) Date of filing: **09.10.2023**

(51) International Patent Classification (IPC):
$G01R\ 31/367\ ^{(2019.01)}$    $G01R\ 31/378\ ^{(2019.01)}$
$G01R\ 31/3835\ ^{(2019.01)}$    $G01R\ 31/392\ ^{(2019.01)}$
$H01M\ 10/0525\ ^{(2010.01)}$    $H01M\ 10/48\ ^{(2006.01)}$

(52) Cooperative Patent Classification (CPC):
**G01R 31/367; G01R 31/378; G01R 31/3835;
G01R 31/392; H01M 10/0525; H01M 10/48;
Y02E 60/10**

(54) **DETERMINING PARAMETERS OF A MODEL OF A BATTERY**

BESTIMMUNG VON PARAMETERN EINES MODELLS EINER BATTERIE

DÉTERMINATION DE PARAMÈTRES D'UN MODÈLE D'UNE BATTERIE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(43) Date of publication of application:
**16.04.2025 Bulletin 2025/16**

(73) Proprietor: **TWAICE Technologies GmbH
80807 München (DE)**

(72) Inventors:
• **KIRST, Cedric
81375 München (DE)**
• **KARGER, Alexander
81667 München (DE)**
• **SINGER, Jan
80336 München (DE)**

(74) Representative: **Kraus & Lederer PartGmbB
Thomas-Wimmer-Ring 15
80539 München (DE)**

(56) References cited:
**US-A1- 2021 359 347**

• **CHEN CHANG-HUI ET AL: "Development of
Experimental Techniques for Parameterization of
Multi-scale Lithium-ion Battery Models", vol. 167,
no. 8, 5 January 2020 (2020-01-05), pages 080534,
XP093134366, ISSN: 0013-4651, Retrieved from
the Internet <URL:https://iopscience.iop.org/
article/10.1149/1945-7111/ab9050/pdf> [retrieved
on 20240226], DOI: 10.1149/1945-7111/ab9050**
• **ANDREW WENG ET AL: "Differential voltage
analysis for battery manufacturing process
control", ARXIV.ORG, CORNELL UNIVERSITY
LIBRARY, 201 OLIN LIBRARY CORNELL
UNIVERSITY ITHACA, NY 14853, 13 March 2023
(2023-03-13), XP091459767**

**Description**

TECHNICAL FIELD

The present application relates to a method and a device for determining parameters of a model of a battery based on open circuit voltage measurements.

BACKGROUND

Lithium-ion batteries are widely used in energy storage devices for many applications, e.g., in the mobility or energy sector. Their economic viability and their ecological footprint depend directly on how long a battery can be used for its application, since increased lifetime correlates with lowered costs and carbon emissions per stored amount of energy. Thus, degradation is a key concern during lithium-ion battery system development and usage.

While experiments, both destructive and life cycle testing, provide essential information, much can be accomplished by models, provided they are proven to be reliable in predicting degradation. In this context, aging models are often parameterized and used.

However, parameterization of aging models remains a challenge. It has been found that aging models can sometimes yield inaccurate results.

The US patent application US 2021/359347 A1 describes an electrical device including a battery cell, a voltage sensor operatively coupled to the battery cell in order to measure a voltage level of the battery cell, a current sensor operatively coupled to the battery cell in order to measure an amount of current drawn from or supplied to the battery cell, and a battery management system (BMS). The battery management system includes a controller in communication with the voltage sensor and the current sensor. The controller is configured to execute a program stored in the BMS to calculate a state of health of the individual battery electrodes comprising a battery cell using a first differential voltage point, a second differential voltage point, and a characteristic curve of a fresh battery electrode of a fresh battery cell, wherein the battery cell includes a second battery electrode not exhibiting distinct phase transitions during a charge-discharge cycle.

The article having the title "Development of Experimental Techniques for Parameterization of Muli-scale Lithium-ion Battery Models" by Chen Chang-Hui et al, in the Journal of the Electrochemical Society, vol. 167, published May 15, 2020, describes a set of experimental data relating to a cylindrical 21700 commercial cell (LGM50), for an electrochemical pseudo-two-dimensional (P2D) model.

The article having the title "Differential Volage Analysis for Battery Manufacturing Process Control" by Andrew Weng et al, in arxiv.org, published March 13, 2023, describes a voltage-based battery metric for battery manufacturing diagnostics.

SUMMARY

Accordingly, a need exists for advanced techniques of estimating parameters of battery models. Specifically, a need exists for advanced techniques that facilitate accurate estimation of parameters of models of rechargeable batteries that provide information on degradation mechanisms inside the battery.

This need is met by the features of the independent claims. The features of the dependent claims define embodiments.

A computer-implemented method includes obtaining a plurality of open circuit voltage (OCV) curves of a battery at a plurality of predefined charge cycles of the battery.

Each of the OCV curves is indicative of an OCV over a predetermined charge range of the corresponding charge cycle. The method further includes fitting parameters of a model of the battery based on the plurality of OCV curves. The parameters include electrode parameters that model a corresponding open circuit electrode potential for each electrode of the battery. As used herein, the term charge cycle may include charging the battery, i.e. increasing the amount of charge in the battery, discharging the battery, i.e. decreasing the amount of charge in the battery, or any combination of charging and discharging.

In various embodiments, between obtaining a given OCV curve of the plurality of OCV curves and obtaining a following OCV curve of the plurality of OCV curves, a predefined number of equivalent full charge and discharge cycles of the battery are performed. For example, between the acquisition of each two successive OCV curves, 30, 50, 80 or 100 of equivalent full charge and discharge cycles of the battery can be performed. The acquisition of the plurality of OCV curves can be spanned over the life of the battery, i.e. until the battery reaches the end of its life.

The predetermined charge range may cover for example a full charge with a predetermined charge current or a full discharge at a predetermined discharge current. A full charge or discharge may include a charge over a range of nearly 0% to nearly 100% of the battery capacity, especially over the maximum rated range of the battery. In further examples, a full charge or discharge may include a charge over a range of 2% to 98% or 5% to 95% of the battery capacity.

In further examples, the predetermined charge range may cover a full charge with a predetermined charge current and a full discharge at a predetermined discharge current.

The charge current and/or the discharge current may be less than the rated capacitance of the battery divided by 10 hours, a so-called C/10 current, preferably divided by 20 hours, a so-called C/20 current (with C designating the rated capacity of the battery in Ah). The OCV may be a pseudo OCV, i.e., the OCV curve is obtained while the battery is continuously charged or discharged with a low current, e.g., C/10, C/20 or even less. The OCV curve may be obtained using a galvanostatic intermittent titration technique (GITT). The GITT may include a plurality of charging or discharging steps each followed by a relaxation time step in which essentially no charging or discharging current is applied. The GITT may be performed with a current rate of about C/20 to C/10 or up to C/5 for about 5 to 30 min in the charging or discharging step. The relaxation time may be varied in a range of for example 30 min to 10 h, as the time to reach the equilibrium state after the charging/discharging step.

In various examples, the fitting of the parameters is based on a consideration of the obtained OCV curves and modelled OCV curves that are based on the modelled open circuit electrode potentials. For fitting the parameters, at least some of the parameters of the model are varied to minimize at least one of a first sum of errors, a second sum of errors, a third sum of errors and/or a fourth sum of errors. The first sum of errors is obtained based on the OCVs of one of the obtained OCV curves and corresponding OCVs of a corresponding one of the modelled OCV curves. The second sum of errors is obtained based on a first discrete derivate of the OCVs with respect to a state of charge of one of the obtained OCV curves and a first discrete derivate of corresponding OCVs with respect to a state of charge of a corresponding one of the modelled OCV curves. The third sum of errors is obtained based on the OCVs of all of the obtained OCV curves and corresponding OCVs of all corresponding modelled OCV curves. The fourth sum of errors is obtained based on a first discrete derivate of the OCVs with respect to a state of charge of all of the obtained OCV curves and a first discrete derivate of corresponding OCVs with respect to a state of charge of all corresponding modelled OCV curves.

Each sum of errors mentioned above may comprise, for example, a Root Mean Squared Error (RMSE), or any other error or distance function, e.g., a Mean Absolute Error (MAE) or a maximum absolute error.

The fitted parameters comprise at least one charge cycle specific parameter that changes over lifetime of the battery, and at least one charge cycle unspecific parameter that does not change over lifetime of the battery.

Fitting the one or more charge cycle specific parameters may comprise, for each of the plurality of predefined charge cycles, varying the charge cycle specific parameters to minimize the first sum, the second sum or a sum of the first sum and the second sum relating to the obtained and modelled OCV curves corresponding to the charge cycle of the charge cycle specific parameters.

Fitting the one or more charge cycle unspecific parameters may comprise varying the charge cycle unspecific parameters to minimize the third sum, the fourth sum or a sum of the third sum and the fourth sum.

Thus, a bi-level optimization algorithm may be performed, fitting the one or more charge cycle specific parameters and fitting the one or more charge cycle unspecific the parameters. For example, fitting the one or more charge cycle specific parameters and fitting the one or more charge cycle unspecific parameters may be performed successively and this sequence may be repeated for a predetermined number of repetitions or until a predefined convergence criterion for the parameters is reached.

According to various examples, the parameters comprise for each electrode a charge cycle specific mean value and a charge cycle specific standard deviation that relate to the capacity of the electrode in the model. In further examples, the parameters comprise a charge cycle specific capacity of usable lithium that is cyclable in the battery during charging and discharging the battery. When at least one of the electrodes of the battery is a blend electrode that comprises at least two coexisting electrode materials, the parameters may comprise for each blend electrode a charge cycle specific capacity ratio between the coexisting materials.

Generally, in a lithium-ion battery, lithiation and delithiation of each electrode may result in multiple phase transitions. For example, each electrode material may have a predefined number of phase transitions. For example, Lithium intercalation in a carbon electrode may include phase transitions between $Li_xC_y$ stages 1 ($LiC_6$), 2 ($LiC_{12}$), 3L ($LiC_{18}$) and 4L ($LiC_{24}$). In some examples, the parameters comprise for each electrode material of each electrode an interaction energy approximation parameter relating to an interaction energy of different phase transitions of lithiation and/or delithiation of the electrode materials in the electrode. In some further examples, the parameters comprise for each phase transition of each electrode material of each electrode a stored relative charge parameter indicating a fraction of charge stored by the phase transition relative to the electrode capacity. In some examples, the parameters comprise for each phase transition of each electrode material of each electrode an equilibrium potential parameter indicating an equilibrium electrode potential of the corresponding phase transition.

The interaction energy approximation parameters, the stored relative charge parameters, and the equilibrium potential parameters may be charge cycle unspecific parameters, i.e. these parameters do not vary or do not vary significantly over lifetime of the battery.

The mean value and standard deviation relating to the capacity of each electrode, the capacity of usable lithium, and the capacity ratio between the coexisting materials in each electrode may be charge cycle specific parameters, i.e.

**EP 4 538 724 B1**

these parameters vary significantly over lifetime of the battery, may reduce the overall capacity of the battery over lifetime and thus contribute to the aging of the battery.

As described above, the method provides a bi-level optimization algorithm as a non-destructive method to estimate electrode potential curves, electrode capacities and the capacity of usable lithium over lifetime. By applying the above method, additional estimates of electrode capacities over lifetime, capacity of usable lithium over lifetime, silicon content in the negative electrode over lifetime and a quantification of electrode degradation homogeneity over lifetime may be obtained.

In further examples, an aging model of the battery is parameterized based on the fitted parameters. The aging model may further consider battery stress factors, such as temperature, depth of cycle, state of charge, and charge-discharge rates. A state of health may be determined for a further battery having the same type as the analyzed battery based on the parameterized aging model and the stress factors obtained during a previous operation of the further battery. In other words, by applying the stress factors to the parameterized model, a digital twin of the further battery is obtained and a state of health and even internal states, e.g., electrode capacities and the capacity of usable lithium, can be estimated. Also, aging of the further battery can be reliably simulated with the parameterized aging model such that charging strategies and temperature control can be adapted accordingly to increase battery lifetime.

A device for determining parameters of a model of a battery is coupleable to a controllable charge circuit for the battery and a measurement circuit configured to measure a voltage at the battery. The device comprises a control circuit configured to control the charge circuit to perform a plurality of predefined charge cycles of the battery. The control circuit obtains from the measurement circuit a plurality of OCV curves of the battery at the plurality of predefined charge cycles of the battery. Each of the OCV curves is indicative of an OCV over a predetermined charge range of the corresponding charge cycle. Furthermore, the control circuit is configured to fit the parameters of the model of the battery based on the plurality of OCV curves. The parameters include electrode parameters that model a corresponding open circuit electrode potential for each electrode of the battery.

BRIEF DESCRIPTION OF THE DRAWINGS

FIG. 1 schematically illustrates a device according to various examples in connection with a battery.

FIG. 2 is a flowchart of a computer-implemented method according to various examples.

FIG. 3 schematically illustrates charge cycles and corresponding open-circuit voltage curves according to various examples.

FIG. 4 schematically illustrates an electrical potential $\Phi$ over stoichiometry x of a model parameterized to a single phase transition.

FIG. 5a schematically illustrates electrical potentials of modelled phase transitions between $Li_xC_y$ stages 1, 2, 2L, 3L, 4L and 1L over scaled stoichiometry $\Delta X_i * X_i$.

FIG. 5b schematically illustrates an electrical potential vs. Li/Li$^+$ of lithium-graphite anode as cumulative sum of the stored relative charge during each phase transition corresponding to FIG. 5a.

FIG. 6a schematically illustrates potentials over stoichiometry of a graphite model and a silicon model.

FIG. 6b schematically illustrates potentials over stoichiometry of graphite blend electrode models containing different contents of silicon.

FIG. 7 schematically illustrates a positive electrode potential and a negative electrode potential resulting from normal distributed electrode capacities with mean capacities $C_{PE}$ and $C_{NE}$ and standard deviations $\sigma_{PE}$ and $\sigma_{NE}$, and a corresponding full cell voltage.

FIG. 8 is a flowchart of a computer-implemented bi-level fitting algorithm according to various examples.

FIG. 9a, 9b and 9c schematically illustrate modelled and measured full cell voltages and electrode potentials over full cell SoC of different battery types.

4

FIG. 10a, 10b and 10c schematically illustrate measured and modelled voltages and their first derivatives with respect to SoC over full cell SoC of a first and last OCV charge cycle of different battery types.

FIG. 11a and 11b schematically illustrate aging dependent outputs of a bi-level optimization algorithm over Equivalent Full Cycles.

DETAILED DESCRIPTION

Some examples of the present disclosure generally provide for a plurality of circuits or other electrical devices. All references to the circuits and other electrical devices and the functionality provided by each are not intended to be limited to encompassing only what is illustrated and described herein. While particular labels may be assigned to the various circuits or other electrical devices disclosed, such labels are not intended to limit the scope of operation for the circuits and the other electrical devices. Such circuits and other electrical devices may be combined with each other and/or separated in any manner based on the particular type of electrical implementation that is desired. It is recognized that any circuit or other electrical device disclosed herein may include any number of microcontrollers, a graphics processor unit (GPU), integrated circuits, memory devices (e.g., FLASH, random access memory (RAM), read only memory (ROM), electrically programmable read only memory (EPROM), electrically erasable programmable read only memory (EEPROM), or other suitable variants thereof), and software which co-act with one another to perform operation(s) disclosed herein. In addition, any one or more of the electrical devices may be configured to execute a program code that is embodied in a non-transitory computer readable medium programmed to perform any number of the functions as disclosed.

In the following, embodiments of the invention will be described in detail with reference to the accompanying drawings. It is to be understood that the following description of embodiments is not to be taken in a limiting sense. The scope of the invention according to the independent claims is not intended to be limited by the embodiments described hereinafter or by the drawings, which are taken to be illustrative only.

The drawings are to be regarded as being schematic representations and elements illustrated in the drawings are not necessarily shown to scale. Rather, the various elements are represented such that their function and general purpose become apparent to a person skilled in the art. Any connection or coupling between functional blocks, devices, components, or other physical or functional units shown in the drawings or described herein may also be implemented by an indirect connection or coupling. A coupling between components may also be established over a wireless connection. Functional blocks may be implemented in hardware, firmware, software, or a combination thereof.

Various disclosed examples generally pertain to state estimation of one or more hidden states of a battery. For instance, state estimation can be applied to rechargeable batteries such as lithium-ion batteries.

According to various examples, it is possible to determine an open-circuit voltage curve (OCV), i.e., a dependency of the OCV on the state of charge (SOC). The OCV curve can be determined for a current aging state of the battery. The OCV is defined as the open-circuit potential difference between cathode and anode of the battery. A shape and/or amplitude of the OCV curve can be determined.

Based on the OCV curve, it may be possible to determine one or more estimates of states of the battery. For instance, it would be possible to determine the aging state of the battery, e.g., a state of health (SOH) of the battery. Typically, both the capacity, as well as the impedance of the battery will change as a function of age of the battery. Thus, to make a prediction of the available capacity, it is helpful to determine the SOH.

Various techniques disclosed herein are based on the finding that the OCV curve will change its shape as a function of progressive aging of the battery. Thus, by determining the OCV curve for the current aging state of the battery, based on the shape of the OCV curve, it is possible to make an estimate of the aging state of the battery.

Specifically, by estimating the aging state of the battery based on the OCV curve, it has been found that a more accurate estimate of the aging state if compared to prior art techniques is possible. The underlying reason is that the OCV curve serves as a unique fingerprint capturing all different kinds of degradation modes of the battery.

Such techniques are based on the finding that it is helpful to consider the interactions between degradation mechanisms or modes, as the behavior of combined mechanisms cannot always be reproduced by combining individual mechanisms. Empirical models can capture this combined behavior, but they can only provide insight into how to prevent degradation when combined with physics-based models.

Degradation modes may include electrode capacity degradation as well as capacity degradation of usable lithium. Electrode capacity degradation and capacity degradation of usable lithium over lifetime may enable applications to reconstruct the OCV over charge at arbitrary points in a Li-ion battery's lifetime. Such an OCV aging model may require information about the positive and negative electrode potential curves over stoichiometry or charge. Electrode potential curves may be used to estimate the electrode capacities as well as the capacity of usable lithium over lifetime by applying a method of half cell fitting. These estimated component states form the parameterization dataset for the model, and further enable the reconstruction of the aged OCV under arbitrary aging conditions. One way to obtain electrode potential curves from commercial Li-ion batteries is to disassemble the full cells in a glovebox in order to harvest and measure electrode half cells. Problems of this method are the deployment of different electrolytes and different separators in the harvested half cells compared to the full cell. Further, the method requires advanced electrochemical laboratory equipment such as a glovebox.

To sum up, a model considering parameters for each electrode separately may provide reliable information over lifetime of the battery but requires parameters that may be difficult to be determined directly at the battery in a non-destructive way.

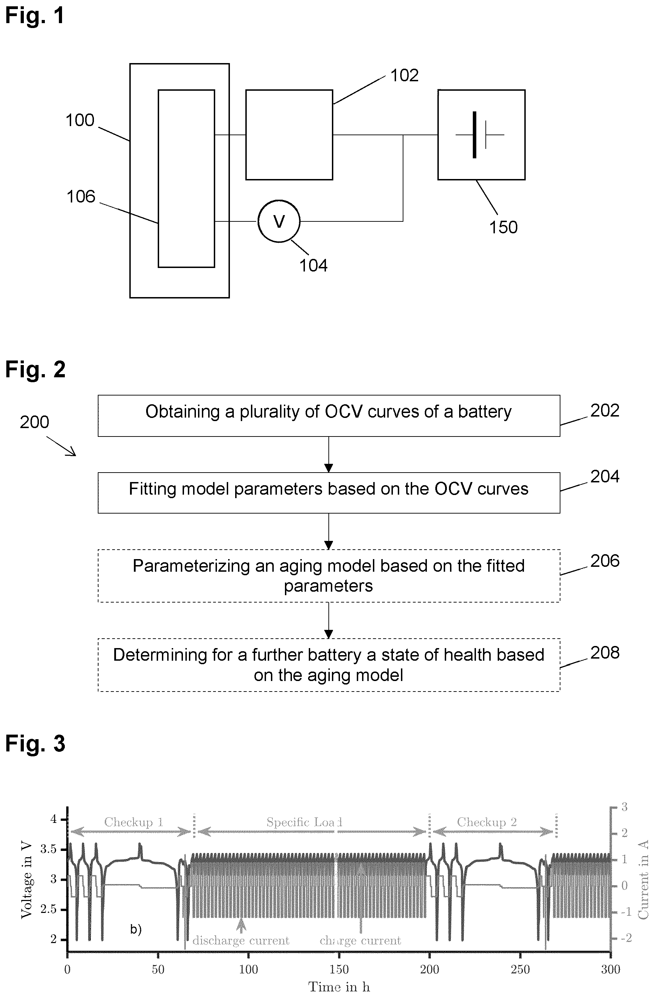

Therefore, a model and fitting approach are provided to estimate electrode potential curves, electrode capacities and the capacity of usable lithium over lifetime based on OCV curves. The model and fitting approach may be implemented by a computer implemented method that may be executed by device 100 shown in FIG. 1. The device may comprise or may be coupled to a controllable charge circuit 102 couplable to a battery 150 and a measurement circuit 104 configured to measure a voltage at the battery 150. The device 100 comprises a control circuit 106 coupled to the controllable charge circuit 102 and the measurement circuit 104. The control circuit 106 may comprise a computer system including a central processing unit (CPU), main memory (RAM, ROM, FLASH etc.) and mass storage (hard disc, FLASH, etc.) as well as a user interface.

Operation of the control circuit is described in more detail in connection with FIG. 2. FIG. 2 shows a method 200 comprising method steps 202 to 208. Optional method steps (e.g. steps 206 and 208) are indicated by dashed boxes. As indicated in FIG. 1, the battery 150 is coupled to the controllable charge circuit 102 and the measurement circuit 104.

In step 202, the control circuit 106 controls the charge circuit 102 to perform a plurality of predefined charge cycles to obtain aging data of the battery 150. The battery 150 may be a single cell or may comprise a plurality of cells, for example cells of the same type. However, in the below described model the battery 150 may be assumed to be a single cell, i.e., the battery 150 is modeled as a single anode, a single cathode and an electrolyte between anode and cathode.

Each charge cycle may charge and/or discharge the connected battery 150 at least partially. While charging and discharging the battery 150, the control circuit 106 may obtain OCV curves of the battery by means of the measurement circuit 104. Each of the OCV curves are indicative of an OCV over a predetermined charge, a predetermined discharge or a predetermined sequence of a charge and discharge of the corresponding charge cycle.

FIG. 3 shows an example of a plurality of charge cycles for obtaining OCV curves. The plurality of charge cycles includes several charge cycles in so-called checkup phases and several charge cycles in so-called specific load phases. The exemplary plurality of charge cycles shown in FIG. 3 include a first checkup phase (checkup 1), followed by a specific load phase, followed by a second checkup phase (checkup 2), followed by a specific load phase which is only partially shown. Further specific load phases alternating with checkup phases may follow until the end of the battery's life is reached.

Generally, a charge or discharge current can be indicated directly by its current in Ampere (A) or as a quotient of the rated capacity C of the battery in Ah divided by a theoretical time in hours for a complete charge or discharge. E.g., a charge current of C/10 (complete discharge or charge in 10 hours) for a batterie having a capacity of 3 Ah is 3Ah/10h=0.3A.

Each specific load phase may involve a number of charge and discharge cycles at high current, for example 50 to 200 charge/discharge cycles at a current of C/2 or C/1. Each checkup phase may optionally involve a number of charge and discharge cycles at medium current, for example 2 to 10 charge/discharge cycles at a current in a range of C/3 to C/8, followed by a charge cycle and/or discharge cycle at low current, for example at a current in a range of C/10 to C/20.

In the example shown in FIG. 3, a cell with a capacity of about 3 Ah may be assumed, for example a cell of type 18650. Each load phase may comprise about 60 charge/discharge cycles at about 1000 mA (high current). Each checkup phase may comprise three charge/discharge cycles at 500 mA (medium current) followed by a charge cycle and a discharge cycle at 150 mA (low current).

OCV curves may be obtained by sampling the voltage at the battery during the charge or discharge cycles at low current. Obviously, measuring the voltage at the battery during charging or discharging the battery is not the real "open circuit" voltage and is therefore also called pseudo OCV (pOCV). However, due to the low current, the pOCV curves are very close to OCV curves. In the following, the term OCV will be used regardless of whether the voltage is a "real" OCV, i.e. the voltage is sampled at zero current, or the voltage is a pOCV sampled at low current.

A sampling rate for sampling the OCV may be in a range of 5 to 600 samples per hour. The sampling rate may be adjusted depending on the charge or discharge current (low current). For example, assuming a charge current of 200 mA at a battery having a capacity of 3000 mAh, a time for a full charging of the battery is about 15 hours. With the sampling rate of 20 samples per hours, each OCV curve may be described by 300 samples.

Further techniques for obtaining OCV curves may be used. For example, the OCV curves may be obtained using a Galvanostatic Intermittent Titration Technique (GITT). The GITT may include a plurality of charging or discharging steps each followed by a relaxation time step in which essentially no charging or discharging current is applied, i.e., the above low current is a zero current. The GITT may be performed with a current rate of about C/20 to C/10 or up to C/5 for about 5 to 30 min in the charging or discharging step. The relaxation time may be varied in a range of for example 30 min to 10 h, as the time to reach the equilibrium state after the charging/discharging step. A sample may be taken at the end of each relaxation time.

A battery model including electrode parameters that model a corresponding open circuit electrode potential for each electrode of the battery is provided. In other words, the battery model may include models for each half cell of the battery.

Returning to the method 200 of FIG. 2, in step 204, the parameters of the battery model, in particular the electrode parameters of each half cell model, are fitted based on the plurality of obtained OCV curves.

Optionally, in step 206, an aging model may be parameterized based on the fitted parameters and a state of health of a further battery may be determined based on the parameterized aging model in step 208.

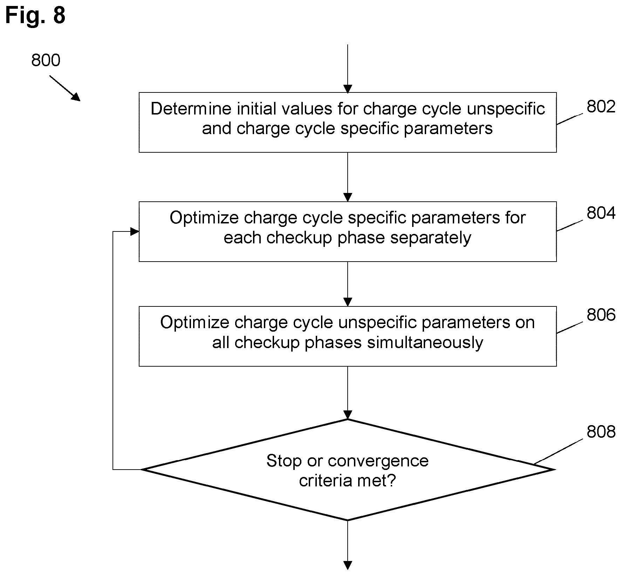

Details on fitting the parameters of the model of the battery based on the plurality of OCV curves will be described in connection with FIG. 8. First, however, details on the deployed model will be described.

In an electrochemical intercalation reaction, the isothermal partial derivative of the free energy $F$ with respect to the number of intercalated atoms $n$ defines the chemical potential $\mu$ at temperature $T$ according to equation (1).

$$\mu = \left(\frac{\delta F}{\delta n}\right)_T \tag{1}$$

The electrical potential $\Phi$ may be derived from the negative chemical potential $\mu$ by division through the elementary charge e and the charge number $z$, which equals z = 1 in case of Li-ion batteries. See equation (2).

$$\Phi = -\frac{1}{z * e} * \mu \tag{2}$$

Considering the stoichiometry $x$ as the ratio between the number of intercalated atoms $n$ and the number of open sites $N$ (see equation (3)), the partial derivative of the free energy $F$ with respect to the stoichiometry x correlates to the electrical potential $\Phi(x)$ according to equation (4).

$$x = \frac{n}{N} \tag{3}$$

$$\Phi(x) = -\frac{1}{Ne} * \left(\frac{\delta F}{\delta x}\right)_T \tag{4}$$

The free energy of reaction $F$ equals the difference between the enthalpy of reaction $E$ and the entropy $S$ multiplied by temperature $T$. See equation (5).

$$F = E - T * S \tag{5}$$

Considering a single phase transition, the enthalpy $E$ of the intercalation reaction correlates to the number of intercalated atoms $n$ multiplied by the energy $E_0$ of each intercalated atom. See equation (6).

$$E = n * E_0 \tag{6}$$

Hence, the enthalpy of reaction $E(x)$ shows a linear dependency on the stoichiometry $x$. See equation (7).

$$E(x) = x * N * E_0 \tag{7}$$

As this description of the enthalpy neglects the interaction energy $E_{int}$ between $\gamma$ adjacent ions, the enthalpy $E(x)$ may be extended as a function of stoichiometry by the stoichiometry dependent formulation of the interaction energy. See equation (8).

$$E(x) = x * N * E_0 + N * \gamma E_{int}(x - x^2) \tag{8}$$

The entropy $S$ equals the Boltzmann constant $k$ times the logarithm of the number of ways to place $n$ atoms on $N$ sites. See equation (9).

$$S = k * ln \binom{N}{n} = k * ln \left( \frac{N!}{n! \, (N-n)!} \right)$$

$$= k * \big[ \ln(N!) - \ln(n!) - \ln\big((N-n)!\big) \big] \tag{9}$$

By using Stirling's approximation (equation (10))

$$\ln(a!) = a * \ln(a) - a + O[\ln(a)] \tag{10}$$

the entropy S may be transformed according to equation (11).

$$S = k * [N * \ln(N) - N - n * \ln(n) + n - (N-n) * \ln(N-n) + (N-n)]$$

$$= kN * \left[ ln \left( \frac{N}{N-n} \right) - \frac{n}{N} * \ln \left( \frac{n}{N-n} \right) \right] \tag{11}$$

The substitution of the number of intercalated atoms n by the stoichiometry x and the number of sites N as shown in equation (3) leads to the entropy S as a function of stoichiometry x. See equation (12).

$$S(x) = kN * \left[ ln \left( \frac{1}{1-x} \right) - x * \ln \left( \frac{x}{1-x} \right) \right]$$

$$= -kN * [x * \ln(x) + (1-x) * \ln(1-x)] \tag{12}$$

Combining equations (5), (8) and (12) leads to the free energy F as a function of stoichiometry x according to equation (13) with the contribution of the interaction energy $E_{int}$ between $\gamma$ adjacent ions.

$$F(x) = E(x) - t * S(x)$$

$$= N\{E_0 x + \gamma E_{int}(1-2x) + kT[x * \ln(x) + (1-x) * \ln(1-x)]\} \tag{13}$$

Similar to equation (4), the partial derivative of the free energy F with respect to the stoichiometry x results in the electrical potential $\Phi(x)$ according to equation (14).

$$\Phi(x) = \Phi_0 + \Phi_{\text{int}} * (1-2x) + \frac{kT}{e} * ln \left( \frac{x}{x-1} \right) \tag{14}$$

$$with \quad \Phi_0 = -\frac{E_0}{e} \quad and \quad \Phi_{\text{int}} = -\frac{\gamma E_{int}}{e}$$

This electrochemical description of the electrical potential as a function of stoichiometry may be valid for a single phase transition only. In a Li-ion battery, the lithiation and delithiation of an electrode result in multiple consecutive phase transitions. Between these phase transitions, the stored charge adds up. In order to solve equation (14) for the stoichiometry x, the contribution of the interaction energy may be approximated by a correction parameter a resulting in the potential $\Phi(x)$ as a function of stoichiometry x according to equation (15).

$$\Phi(x) = \Phi_0 + \frac{kT}{ae} * ln \left( \frac{x}{x-1} \right), \quad with \quad \Phi_0 = -\frac{E_0}{e} \tag{15}$$

From equation (15) the stoichiometry x may be determined as a function of the open circuit electrical potential $\Phi^{OC}$. See equation (16).

$$x(\Phi^{OC}) = \frac{1}{1 + exp\{(\Phi^{OC} - \Phi_0) * ae/kT\}} \tag{16}$$

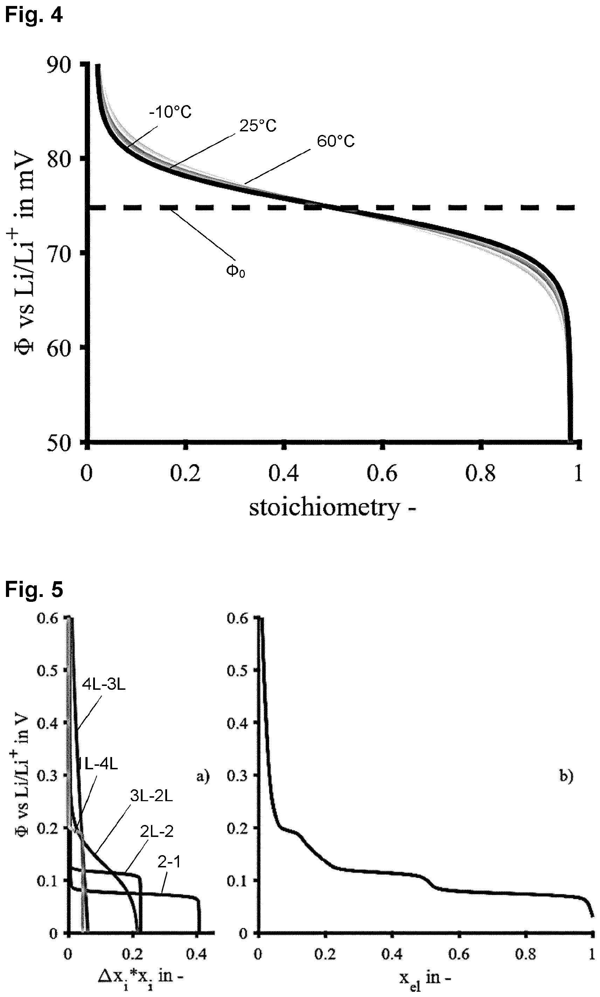

FIG. 4 shows the electrical potential over stoichiometry of a model parameterized to the phase transition reaction according to equation (17) in a lithium-graphite electrode at different temperatures.

$$Li^+ + LiC_{12} + e^- \rightarrow 2\, LiC_6 \tag{17}$$

A dashed line marks the equilibrium potential $\Phi_0$. The interaction energy approximation parameter $a$ has an inverse influence on the potential curve compared to the temperature $T$.

As notes above, in a Li-ion battery, the lithiation and delithiation of an electrode may result in multiple consecutive phase transitions. The overall stored charge q within an electrode consisting of $N$ phase transitions, equals the sum of charges $q_i$ stored in each phase transition $i$. See equation (18).

$$q = \sum_{i=1}^{N} q_i \tag{18}$$

The overall electrode stoichiometry $x_{el}$ equals the stored charge q divided by the electrode capacity $C_{el}$. See equation (19).

$$x_{el} = \frac{q}{C_{el}} \tag{19}$$

By substituting the charge $q$ according to equation (18), the cumulative sum of $N$ single phase transition stoichiometries describes the electrode stoichiometry $x_{el}$ where $x_i$ is the phase transition stoichiometry, $C_i$ the maximum phase transition capacity and $\Delta x_i$ the fraction of charge stored by transition i relative to the electrode capacity. See equation (20).

$$x_{el} = \frac{1}{C_{el}} \sum_{i=1}^{N} q_i = \sum_{i=1}^{N} x_i * \Delta x_i \quad with \quad x_i = \frac{q_i}{C_i} \quad and \quad \Delta x_i = \frac{C_i}{C_{el}} \tag{20}$$

The substitution of the single phase transition stoichiometry $x_i$ as a function of the electrical potential $\Phi^{OC}$ as shown in equation (16) leads to the final electrode stoichiometry model as a function of the potential. See equation (21).

$$x(\Phi^{OC}) = \sum_{i=1}^{N} \frac{\Delta x_i}{1 + exp\left\{(\Phi^{OC} - \Phi_{0,i})a_i * \frac{e}{kT}\right\}} \tag{21}$$

This model, sometimes labelled as Multi-Species-Multi-Reaction (MSMR) model, is a widespread description of electrode potentials. FIG. 5a shows a lithium-graphite potential $\Phi$ over scaled stoichiometry $\Delta x_i * x_i$ of all modelled phase transitions separately. FIG. 5b shows the corresponding potential over stoichiometry of the lithium graphite electrode as cumulative sum of all phase transitions.

The electrical potential of an electrode at a specific lithiation is a material property. In case of blend electrodes, where two electrode materials coexist with a binding material as a connection, the electrical potential at a specific lithiation approximately depends on the capacity ratio between the two materials.

A common blend electrode material combination in commercial Li-ion cells is silicon-graphite. While non-blend electrodes effectively do not change the potential as a function of lithiation over lifetime, blend electrodes can change the capacity ratio between the used materials in case the capacities of the two materials degrade differently. This results in a change of the potential as a function of lithiation over lifetime. A blend electrode model may be introduced, where the electrode stoichiometry $x_{el}$ equals the weighted sum of the two separate stoichiometries $x_1$ and $x_2$ of the utilized electrode materials with $\gamma$ describing the blend capacity ratio. See equation (22).

$$x_{el} = \gamma * x_1 + (1 - \gamma) * x_2 \tag{22}$$

Combining equations (22) and (21) concludes in a blend electrode model stoichiometry as a function of electrical potential with $N$ and $L$ modelled phase transitions of the two blend electrode materials respectively.

$$x(\Phi^{OC}) = \gamma * \sum_{i=1}^{N} \frac{\Delta x_i}{1 + exp\left\{\left(\Phi^{OC} - \Phi_{0,i}\right) * \frac{a_i e}{kT}\right\}}$$

$$+ (1 - \gamma) * \sum_{j=1}^{L} \frac{\Delta x_j}{1 + exp\left\{\left(\Phi^{OC} - \Phi_{0,j}\right) * \frac{a_j e}{kT}\right\}} \tag{23}$$

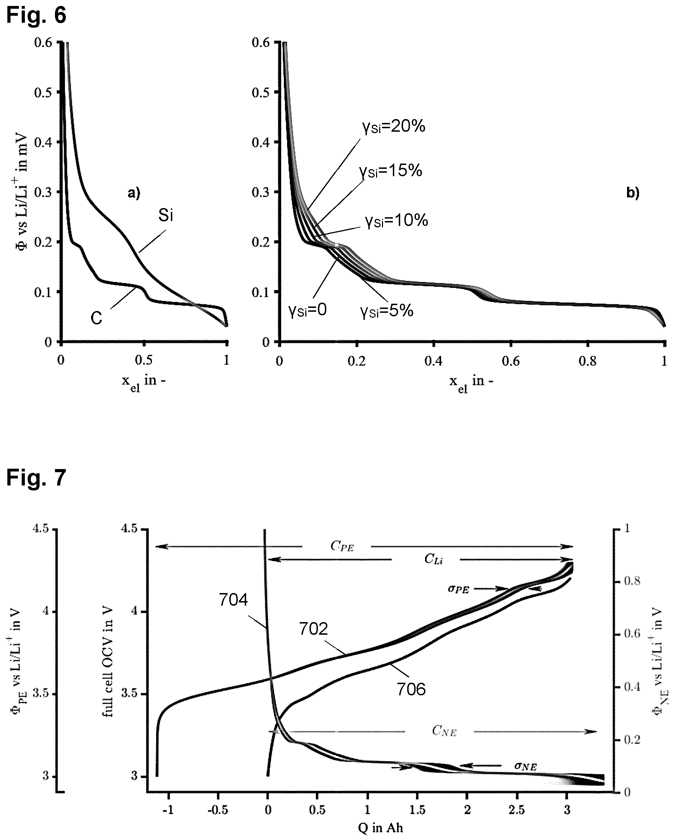

FIG. 6a shows the potential over stoichiometry of the two materials graphite and silicon separately, i.e., differentiating the capacity loss. FIG. 6b shows the potential curve over stoichiometry of graphite blend electrodes containing different contents of silicon. The potential difference between positive and negative electrode defines the full cell open circuit voltage over charge. The capacity of the positive electrode $C_{PE}$ and the capacity of the negative electrode $C_{NE}$ describe the scaling of the respective electrode open circuit potentials (OCPs) over charge in x-direction mathematically. The capacity of usable lithium $C_{Li}$ describes the relative position of the electrode potentials over charge to each other. In combination, the three capacities $C_{PE}$, $C_{NE}$ and $C_{Li}$ shape the full cell voltage as a function of charge.

FIG. 7 shows the electrode potentials as well as the full cell voltage over charge with arrows visualizing the capacities $C_{PE}$, $C_{NE}$ and $C_{Li}$. Within the full cell, the current collectors are coated with the positive and negative electrode materials. Both electrode coatings exhibit geometrical properties such as length, width and coating thickness. Depending on the battery usage, the positive and negative electrodes can degrade geometrically inhomogeneously. This may result in a vanishing of distinctive peaks in the first derivative of the open circuit voltage curve with respect to state of charge. A linear distributed electrode capacity with the slope of the distribution as an open parameter may be used. In the exemplary examples disclosed in this application, normal distributions with the mean value of $C_{PE}$ and $C_{NE}$ and the standard deviations $\sigma_{PE}$ and $\sigma_{NE}$ are used to represent the electrode capacities. The electrode potentials over charge $\Phi_{el}(q_{el})$ equals the weighted mean potential due to the normal capacity distribution $N(C_{el}, \sigma_{el})$ with the mean value $C_{el}$ and the standard distribution $\sigma_{el}$. See equation (24).

$$\Phi_{el}(q_{el}) = mean(f^{-1}\{N(C_{el}, \sigma_{el}) * x_{el}(\Phi_{el})\}) \tag{24}$$

FIG. 7 visualizes the potential curve distributions of the positive electrode as a widened curve 702 and the negative electrode as a widened curve 704 having corresponding mean potentials of the electrodes in the corresponding horizontal centers. Arrows $\sigma_{NE}$ and arrows $\sigma_{PE}$ show the corresponding standard deviations. Arrows $C_{PE}$ and $C_{NE}$ mark the mean electrode capacities. Arrows $C_{Li}$ visualize the capacity of usable lithium. The corresponding full cell voltage is indicated by curve 706.

In summary the general full cell open circuit voltage $U_{OC}$ as a function of charge $q$ consists of the two electrode stoichiometry models $x_{el}$ with the blend factor $\gamma_{el}$, the electrode capacity distributions $N(C_{el}, \sigma_{el})$ as well as the capacity of usable lithium $C_{Li}$. See equation (25).

$$U_{OC}(q) = \Phi_{PE}(C_{Li} - q) - \Phi_{NE}(q)$$

$$\Phi_{el}(q_{el}) = mean(f^{-1}\{N(C_{el}, \sigma_{el}) * x_{el}(\Phi_{el})\})$$

$$x_{el}(\Phi) = \gamma_{el} * \sum_{i=1}^{N} \frac{\Delta x_i}{1 + exp\left\{\left(\Phi^{OC} - \Phi_{0,i}\right) * \frac{a_i e}{kT}\right\}} +$$

$$(1 - \gamma_{el}) * \sum_{j=1}^{L} \frac{\Delta x_j}{1 + exp\left\{\left(\Phi^{OC} - \Phi_{0,j}\right) * \frac{a_j e}{kT}\right\}} \qquad (25)$$

Here, the subscript el labels relations, that are valid for the positive electrode, which is labelled with the subscript *PE,* as well as the negative electrode, which is labelled with the subscript *NE.*

In the following, the parameterization of the full cell open circuit voltage model defined in equation (25) will be described.

The model has several degrees of freedom. Each of the $N + L$ phase transitions is defined by the three parameters $\Delta x_i$, $\Phi_{0,i}$, and $a_i$. The ratio $\gamma$ between the blend electrode materials forms an additional degree of freedom, as shown in equation (25). The normal distributed electrode capacities $N(C_{el}, \sigma_{el})$ as well as the capacity of usable lithium $C_{Li}$ form another five degrees of freedom, which define the open circuit voltage on full cell level. TAB. 1 lists all open parameters on electrode and full cell level for $N_{PE}+L_{PE}$ phase transitions of the positive blend electrode as well as $N_{NE}+L_{NE}$ phase transitions on the negative blend electrode.

TAB. 1: Degrees of freedom of general full cell open circuit voltage model

|  | Parameters | Degrees of freedom |
|---|---|---|
| Positive electrode | $\Delta x_i$, $\Phi_{0,i}$, $a_i$, $\gamma_{PE}$, $\Delta x_j$, $\Phi_{0,j}$, $a_j$ | $3*(N_{PE}+L_{PE})+1$ |
| Negative electrode | $\Delta x_i$, $\Phi_{0,i}$, $a_i$, $\gamma_{NE}$, $\Delta x_j$, $\Phi_{0,j}$, $a_j$ | $3*(N_{NE}+L_{NE})+1$ |
| Full cell | $C_{PE}$, $\sigma_{PE}$, $C_{NE}$, $\sigma_{NE}$, $C_{Li}$ | 5 |

In the following, only blend electrodes as negative electrodes will be considered, meaning that $L_{PE} = 0$ and $\gamma_{PE} = 1$. However, this is only an example, and the described techniques can be applied in the same way to batteries with a blend positive electrode and a not-blend negative electrode, batteries with a blend positive electrode and a blend negative electrode, and batteries with a not-blend positive electrode and a not-blend negative electrode.

Considering this model not only for pristine full cells, but also over lifetime of a Li-ion cell, the degrees of freedom form two groups. One group describes material parameters that remain constant over lifetime, i.e., charge cycle unspecific parameters. The other group consists of parameters that change over lifetime, i.e., charge cycle specific parameters. All phase transition parameters $\Delta x_i$, $\Phi_{0,i}$ and $a_i$ may be considered to not depend on a full cells SoH, whereas the electrode capacities $N(C_{el}, \sigma_{el})$, the capacity of usable lithium $C_{Li}$ and the blend ratio $\gamma$ may vary over lifetime. See TAB 2.

TAB. 2: Charge cycle specific and charge cycle unspecific parameters

| Charge cycle unspecific parameters | for each electrode: $a_i$, $\Delta x_i$, $\Phi_{0,i}$, $a_j$, $\Delta x_j$, $\Phi_{0,j}$ |
|---|---|
| Charge cycle specific parameters | $C_{PE}$, $\sigma_{PE}$, $C_{NE}$, $\sigma_{NE}$, $C_{Li}$, $\gamma_{PE}$, $\gamma_{NE}$ |

In combination with an OCV aging, this distinction forms a time series optimization problem. The optimization algorithm to parameterize the model will be explained in the following.

A fitting algorithm may be utilized, in which all degrees of freedom may be parameterized based on measurements conducted on full cell level. The objective function $f_{obj}(\Phi)$ for all optimizations on a single open current or low current full charge may equal the sum of the root mean squared error (RMSE) of the full cell OCV and the RMSE of its first discrete derivative with respect to SoC. See equation (26).

$$f_{obj}(\theta) = \sqrt{\frac{(U_{meas} - U_{model})^2}{n}} + \sqrt{\frac{\left(\frac{\Delta U_{meas}}{\Delta Q} - \frac{\Delta U_{model}}{\Delta Q}\right)^2}{n}} \qquad (26)$$

Other objective functions may be used, e.g. the RMSE only, a mean absolute error (MAE) or a maximum absolute error or any combination thereof.

As described above in connection with FIG. 3, an OCV aging study consisting of at least one cell with low current full charge cycles, which are repeated every n Equivalent Full Cycles (EFC), may be used as an input for the fitting algorithm. Between the low current full charge cycles the electrode capacities $N(C_{el}, \sigma_{el})$, the capacity of usable lithium $C_{Li}$ and the blend ratio $\gamma$ may change due to degradation. Hence, all low current full cell charge cycles within the measurement data contain information about the electrode potentials in different scaled and translated states, as visualized in FIG. 7.

The fitting algorithm may need initial values for all parameters as starting point for optimization/fitting in order to converge. To get model parameters for the lithiation and delithiation of different electrode chemistries, electrode data downloaded from a Li-ion database may be used for fitting an initial electrode parameter guess, e.g. "Review of parameterisation and a novel database (LiionDB) for continuum Li-ion battery models, Prog. Energy 4 (2022)" by A. A. Wang, S. E. O'Kane, F. Brosa Planella, J. L. Houx, K. O'Regan, M. Zyskin, J. Edge, C. W. Monroe, S. J. Cooper, D. A. Howey, E. Kendrick, J. M. Foster. For Nickel-rich cathodes the NMC-811 pseudo open circuit potential (pOCP) may be used, e.g. "Development of Experimental Techniques for Parameterization of Multi-scale Lithium-ion Battery Models, J. Electrochem. Soc. 167 (2020) 080534 " by C.-H. Chen, F. Brosa Planella, K. O'Regan, D. Gastol, W. D. Widanage, E. Kendrick. For graphite anodes, data from "Experimental and theoretical investigation of Li-ion battery active materials properties: Application to a graphite/Ni0.6Mn0.2Co0.2O2 system, Electrochim. Acta 366 (2021) 137428" by O. Chaouachi, J. M. Rety, S. G ' enies, M. Chandesris, Y. Bultel may be used. For silicon as a blend material, data published in "Unraveling the Reaction Mechanisms of SiO Anodes for Li-Ion Batteries by Combining in Situ 7Li and ex Situ 7Li/29Si SolidState NMR Spectroscopy, J. Am. Chem. Soc. 141 (2019) 7014-7027" by K. Kitada, O. Pecher, P. C. Magusin, M. F. Groh, R. S. Weatherup, C. P. Grey may be used.

Based on the initial values the objective function presented in equation (27) may be calculated on all K OCVs and all material parameters may be optimized.

$$f_{obj}(\theta) = \frac{1}{K} \sum_{k=1}^{K} \sqrt{\frac{(U_{meas,k} - U_{model,k})^2}{n}} + \sqrt{\frac{\left(\frac{\Delta U_{meas,k}}{\Delta Q} - \frac{\Delta U_{model,k}}{\Delta Q}\right)^2}{n}} \qquad (27)$$

To estimate the parameters $N(C_{el}, \sigma_{el})$, $C_{Li}$ and $\gamma$ necessary to calculate this error, a bi-level fitting algorithm may be introduced, which optimizes charge cycle specific parameters that change between OCV full charge cycles and charge cycle unspecific parameters that do not change over aging in an alternating manner.

FIG. 8 shows a flow chart 800 of the implemented bi-level optimization which may be performed in step 204 of FIG. 2. In step 802, initial values for charge cycle unspecific parameters (for each electrode: $a_i$, $\Delta x_i$, $\Phi_{0,i}$, $a_j$, $\Delta x_j$, $\Phi_{0,j}$) and charge cycle specific parameters ($C_{PE}$, $\sigma_{PE}$, $C_{NE}$, $\sigma_{NE}$, $C_{Li}$, $\gamma_{PE}$, $\gamma_{NE}$) are determined. For example, for the initial values the charge cycle unspecific and charge cycle specific parameters may be fitted by only using data of the initial OCV charge curve. After the initial fitting converges, in step 804 all charge cycle specific parameters are optimized for each checkup phase separately. With the estimation of charge cycle specific parameters over lifetime, it is then in step 806 possible to optimize all charge cycle unspecific parameters while calculating the objective function for all checkup phases simultaneously. This procedure can be repeated for a certain number of times or until a specific stop criterium is reached in step 808.

To validate the model and fitting process, OCV aging experiments may be conducted on three cells with different positive and negative electrode materials: Lithiumwerks APR-18650-M1B, Sony Murata US-18650-VTC5A and LG Chem INR-18650-MJ1. A Basytec CTS testing device and a Memmert climate chamber may be used to cycle the cells under distinct conditions.

All aging experiments contain low current full charge cycles every 50 EFC with a charge rate of C/10 for the Sony Murata and a charge rate of C/20 for the Lithiumwerks and LG Chem. To validate the electrode models, a pristine Lithiumwerks cell was opened in a glove box and coin cells of the positive and negative electrodes were made against metallic lithium using $90\mu L$ of commercial LP572 as the electrolyte containing 1 mol/L lithium hexaflourophosphate in 3/7 wt% ethylene carbonate and 2 wt% vinylene carbonate. After five formation cycles with a charge rate of C/10, a charge and discharge open circuit potential (OCP) with a charge rate of C/20 on a Biologic BCS-800 testing device was measured.

With this dataset the model parameterization for the positive electrode chemistries LFP, NCA and NMC, in combination with the negative electrode chemistries graphite and silicon-graphite containing different contents of silicon was validated.

The model and fitting procedure were validated using aging experiments of the above three different single cells containing different electrode materials. All three experiments include low current pOCV full charge phases repeated every 50 EFC.

The voltage full cell SoC of each pOCV works as input for the fitting algorithm as described in connection with FIG. 8 above. The output of the bi-level optimization algorithm includes:

- the positive and negative electrode model parameters defining equation (21),
- the blend ratio $\gamma$ of every pOCV defining equation (23),
- the normal distributed positive and negative electrode capacities $N(C_{el}, \sigma_{el})$ of every pOCV and
- the capacity of usable lithium $C_{Li}$ of every pOCV defining equation (25).

In the following, the model voltage error over SoC for pristine and aged pOCVs on full cell level is evaluated. The electrode model may be compared to half cell fitting results based on half cell measurements harvested from pristine cells. Further, all aging dependent algorithm outputs over lifetime may be analyzed.

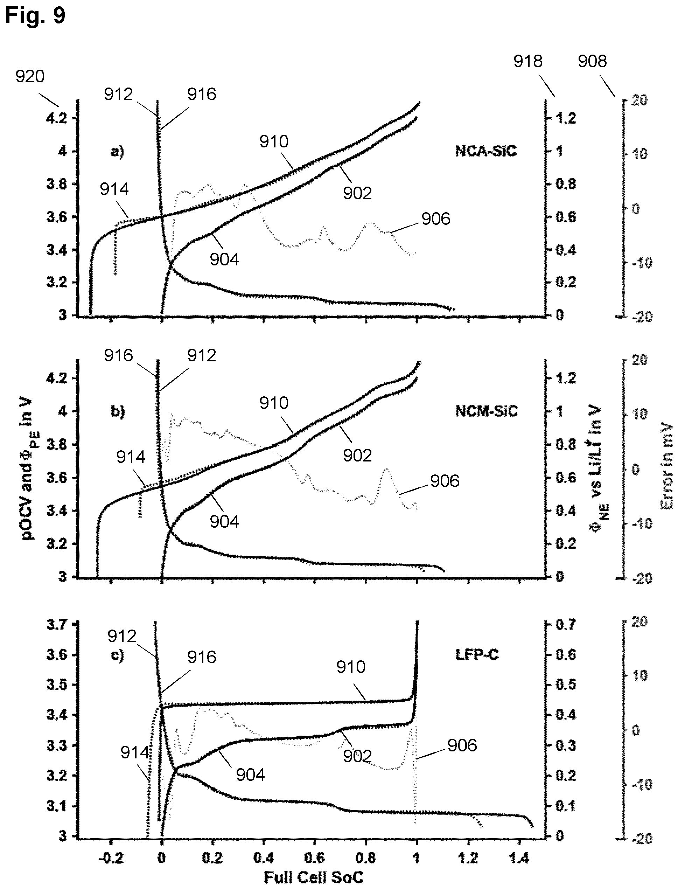

FIG. 9a shows the initial C/10 full charge voltage measurement over full cell SoC of the Sony Murata US-18650-VTC5A (NCA-SiC) cell with by dotted line 902 (scaled on the left y-axis 920). A solid line 904 (scaled on the left y-axis 920) represents the full cell model voltage as the result of the introduced fitting algorithm. A dotted line 906 scaled on the right y-axis 908 visualizes the model voltage error over SoC. A solid line 910 shows the parameterized positive electrode model (scaled on the left y-axis 920) and a solid line 912 shows the parameterized negative electrode model over full cell SoC (scaled on the y-axis 918). As a comparison, dotted lines 914 and 916 represent pristine positive and negative electrode potential curves measured on harvested half cells. The electrode capacities and the capacity of usable lithium of the measured electrode potentials are optimized using equation (27).

FIG. 9b shows the respective fitting results on the initial C/20 full charge measurement on the LG Chem INR-18650-MJ1 (NMC-SiC) cell. FIG. 9c shows the respective fitting results on the initial C/20 full charge Lithiumwerks APR-18650-M1B (LFP-C) cell.

The measured and model-based electrode potential curves in FIG. 9a, 9b and 9c show a similar course over SoC for all cell chemistries within exploited electrode lithiation areas in the full cell.

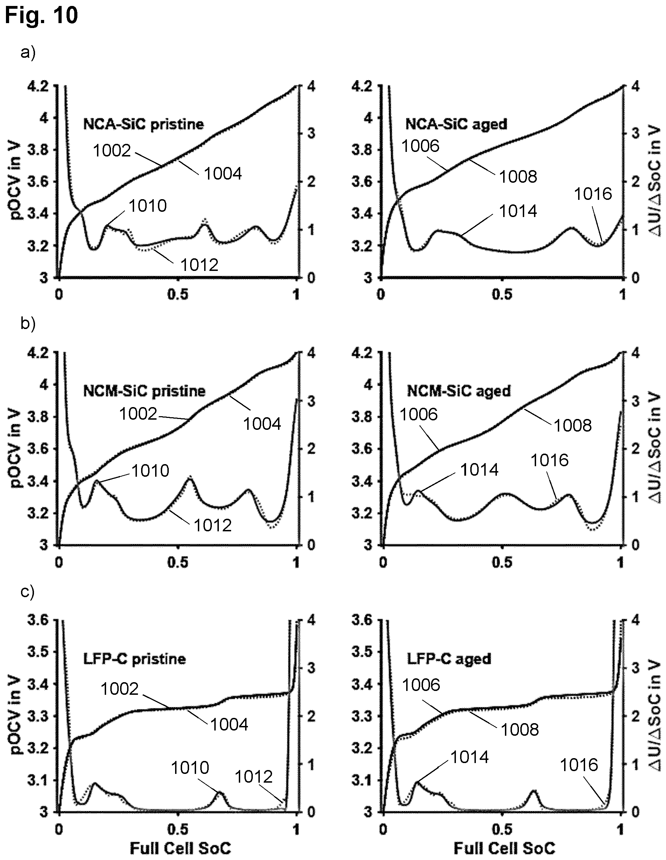

As a validation of the modelling and fitting over lifetime, FIG. 10a shows the measured and modelled voltage and its first derivative with respect to SoC over full cell SoC of the first, i.e. pristine, and last, i.e. aged, pOCV of the Sony Murata US-18650-VTC5A (NCA-SiC) aging data. FIG. 10b shows the respective pristine and aged results of the LG Chem INR-18650-MJ1 (NMC-SiC) cell. FIG. 10c shows the respective pristine and aged results of the Lithiumwerks APR-18650-M1B (LFP-C) cell.

In each diagram, solid curve 1002 shows the modeled OCV of the pristine cell and dotted curve 1004 shows the corresponding measured OCV of the pristine cell, both scaled on the left y-axis. Solid curve 1006 shows the modeled OCV of the aged cell and dotted curve 1008 shows the corresponding measured OCV of the aged cell, both scaled on the left y-axis. Solid curve 1010 shows the modeled first derivative of voltage with respect to SoC of the pristine cell and dotted curve 1012 shows the corresponding measured first derivative of voltage with respect to SoC of the pristine cell, both scaled on the right y-axis. Solid curve 1014 shows the modeled first derivative of voltage with respect to SoC of the aged cell and dotted curve 1016 shows the corresponding measured first derivative of voltage with respect to SoC of the aged cell, both scaled on the right y-axis.

The modelling approach accurately represents the OCV of all validated cell chemistries over lifetime, as all model errors are < 8mV for the initial as well as last OCVs. FIG. 10a, 10b and 10c elucidate the model accuracy over lifetime with the measurement and model voltage over SoC being approximately congruent. Further, the parameterized model correctly depicts chemistry specific OCV features. As an example, the first derivative of the modelled and measured voltage with respect to SoC in FIG. 10c, show the LiC12 peak at an SoC at 0.63 in the initial and at an SoC at 0.69 in the aged curve. Another example is the degradation of silicon over lifetime. A plateau in the first derivative of the initial modelled and measured voltage with respect to SoC in FIG. 10a and 10b at an SoC of 0.05 represents a silicon specific feature of the full cell OCV in model and measurement. This plateau is not present in the aged modelled and measured voltage derivative in FIG. 10a and 10b indicating a decreasing silicon content over lifetime.

Furthermore, chemistry specific features in the initial first derivative of the measured voltage with respect to SoC, such as the $LiC_{12}$ peak at an SoC of 0.6 in FIG. 10a and at an SoC of 0.55 in FIG. 10b are not present in the aged measurement. This behavior may be explained by the inhomogeneous lithiation of the negative electrode due to inhomogeneous degradation. The introduction of normal distributed electrode capacities in the modelling approach leads to the accurate representation of the OCV over lifetime, as the aged first derivative of the model voltage with respect to SoC shows similar behavior in FIG. 10a and 10b.

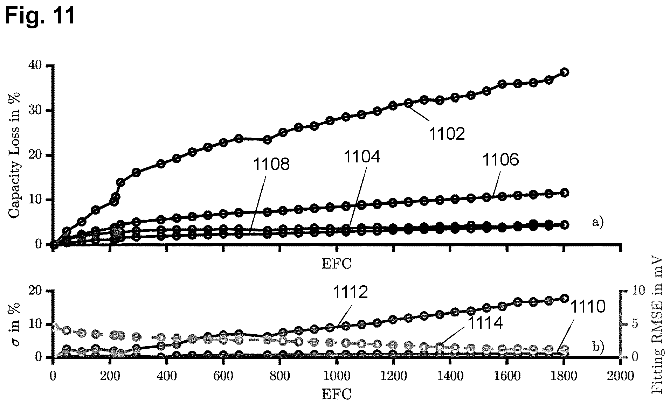

FIG. 11a and 11b shows all estimated aging dependent LG Chem INR-18650-MJ1 parameters over EFC as output of the bi-level optimization algorithm. FIG.11a shows the capacity losses of silicon by graph 1102, graphite by graph 1104, usable lithium by graph 1106 and of the NMC cathode by graph 1108 over EFC. FIG. 11b shows the standard deviation of the normal distributed electrode capacities for the cathode by graph 1110 and the anode by graph 1112, both scaled on the left y-axis, as well as the overall fitting error over EFC by graph 1114 scaled on the right y-axis. At 200 EFC, three consecutive checkup phases result in an increased degradation of the tested cell visible in the loss of lithium inventory in FIG. 11a.

The described model and fitting method accurately represents the full cell behavior over lifetime with all full cell model RMSEs being < 6mV for all checkups in FIG. 11b. The LG Chem cell was cycled in low SoC areas. In this lithiation area the silicon compound may store more charge compared to the graphite compound leading to an increased degradation of available silicon capacity over lifetime as visible in FIG. 11a. Despite the increased degradation of silicon, the most dominant degradation is the loss of lithium inventory. A monotonically increasing standard deviation of the normal distributed negative electrode capacity over EFC in FIG. 11b indicates inhomogeneous active material loss. In contrast, negligible standard deviation of the normal distributed positive electrode capacity indicates a homogeneous lithiation, thus a homogeneous degradation of the positive electrode over lifetime.

In summary, a bi-level optimization algorithm as a non-destructive method to estimate electrode potential curves, electrode capacities and the capacity of usable lithium over lifetime is disclosed. A detailed parameterized model of the battery can be achieved. Based on this, a mechanistic OCV aging model may be built by only using full cell aging data measured with commonly available test equipment.

The aging model may consider battery stress factors, such as temperature, depth of cycle, state of charge, and charge-discharge rates. A state of health may be determined for a further battery of the same type as the analyzed battery based on the parameterized aging model and the stress factors obtained during a previous operation of the further battery. In other word, a digital twin for the analyzed battery type may be obtained and a state of health and internal states, e.g., electrode capacities and the capacity of usable lithium, can be estimated.

Although the invention has been shown and described with respect to certain preferred embodiments, the present invention is limited only by the scope of the appended claims.

**Claims**

1. A computer-implemented method, comprising

   - obtaining (202) a plurality of open circuit voltage curves of a battery (150) at a plurality of predefined charge cycles of the battery, each of the open circuit voltage curves being indicative of an open circuit voltage over a predetermined charge range of the corresponding charge cycle, and
   - fitting (204) parameters of a model of the battery based on the plurality of open circuit voltage curves, the parameters including electrode parameters that model a corresponding open circuit electrode potential for each electrode of the battery,

   wherein the fitted parameters of the model comprise at least one charge cycle specific parameter ($C_{PE}$, $\sigma_{PE}$, $C_{NE}$, $\sigma_{NE}$, $C_{Li}$, $\gamma_{PE}$, $\gamma_{NE}$) that changes over lifetime of the battery, and at least one charge cycle unspecific parameter ($a_i$, $\Delta x_i$, $\Phi_{0,i}$, $a_j$, $\Delta x_j$, $\Phi_{0,j}$) that does not change over lifetime of the battery.

2. The method of claim 1, wherein the predetermined charge range covers at least one of a full charge with a predetermined charge current or a full discharge at a predetermined discharge current.

3. The method of claim 1 or claim 2, further comprising:

   - performing, between obtaining a given open circuit voltage curve of the plurality of open circuit voltage curves and a following open circuit voltage curve of the plurality of open circuit voltage curves, a predefined number of equivalent full charge and discharge cycles of the battery.

4. The method of any one of the preceding claims,

   wherein modelled open circuit voltage curves are based on the modelled open circuit electrode potentials, wherein said fitting (204) of the parameters comprises varying at least some of the parameters of the model to minimize at least one of:

      - a first sum of errors of the open circuit voltages of one of the obtained open circuit voltage curves and corresponding open circuit voltages of a corresponding one of the modelled open circuit voltage curves;

- a second sum of errors of a first discrete derivate of the open circuit voltages with respect to a state of charge of one of the obtained open circuit voltage curves and a first discrete derivate of corresponding open circuit voltages with respect to a state of charge of a corresponding one of the modelled open circuit voltage curves;

- a third sum of errors of the open circuit voltages of all of the obtained open circuit voltage curves and corresponding open circuit voltages of all corresponding modelled open circuit voltage curves; and

- a fourth sum of errors of a first discrete derivate of the open circuit voltages with respect to a state of charge of all of the obtained open circuit voltage curves and a first discrete derivate of corresponding open circuit voltages with respect to a state of charge of all corresponding modelled open circuit voltage curves.

5. The method of claim 4,

wherein the parameters comprise charge cycle specific parameters and charge cycle unspecific parameters, wherein said fitting (204) of the parameters comprises:

- for each of the plurality of predefined charge cycles: varying (804) the charge cycle specific parameters to minimize the first sum, the second sum or a sum of the first sum and the second sum relating to the obtained and modelled open circuit voltage curves corresponding to the charge cycle of the charge cycle specific parameters, and

- varying (806) the charge cycle unspecific parameters to minimize the third sum, the fourth sum or a sum of the third sum and the fourth sum.

6. The method of claim 5, further comprising:

- successively performing said varying of the charge cycle specific parameters and said varying of the charge cycle unspecific parameters and repeating said successively performing for a predetermined number of repetitions or until a predefined convergence criterion for the parameters is reached.

7. The method of any one of the preceding claims, wherein the parameters comprise for each electrode a charge cycle specific mean value and a charge cycle specific standard deviation that relate to the capacity of the electrode in the model.

8. The method of any one of the preceding claims, wherein the parameters comprise a charge cycle specific capacity of usable lithium that is cyclable in the battery during charging and discharging the battery.

9. The method of any one of the preceding claims,

wherein at least one of the electrodes of the battery is a blend electrode comprising at least two coexisting electrode materials, wherein the parameters comprise for each electrode a charge cycle specific capacity ratio between the coexisting materials.

10. The method of any one of the preceding claims,

wherein the battery is a lithium-ion battery, wherein lithiation and/or delithiation of each electrode results in multiple phase transitions, wherein each electrode material has a predefined number of phase transitions, wherein the parameters comprise for each electrode material of each electrode an interaction energy approximation parameter relating to an interaction energy of different phase transitions of lithiation and/or delithiation of the electrode materials in the electrode.

11. The method of any one of the preceding claims,

wherein the battery is a lithium-ion battery, wherein lithiation and/or delithiation of each electrode results in multiple phase transitions, wherein each electrode material has a predefined number of phase transitions, wherein the parameters comprise for each phase transition of each electrode material of each electrode a stored relative charge parameter indicating a fraction of charge stored by the phase transition relative to the capacity of the electrode.

12. The method of any one of the preceding claims,

wherein the battery is a lithium-ion battery, wherein lithiation and/or delithiation of each electrode results in multiple phase transitions, wherein each electrode material has a predefined number of phase transitions, wherein the parameters comprise for each phase transition of each electrode material of each electrode an equilibrium potential parameter indicating an equilibrium electrode potential of the corresponding phase transition.

13. The method of any one of the preceding claims, further comprising:

- parameterizing (206) an aging model of the battery based on the fitted parameters, the aging model including battery stress factors, and
- determining (208) for a further battery having the same type as the battery a state of health based on the aging model and the stress factors obtained during a previous operation of the further battery.

14. A device for determining parameters of a model of a battery, wherein the device is coupleable to a controllable charge circuit (102) for the battery (150) and a measurement circuit (104) configured to measure a voltage at the battery (150), wherein the device (100) comprises:

- a control circuit (106) configured to:

- control the charge circuit to perform a plurality of predefined charge cycles of the battery (150),
- obtain (202), from the measurement circuit, a plurality of open circuit voltage curves of the battery (150) at the plurality of predefined charge cycles of the battery (150), each of the open circuit voltage curves being indicative of an open circuit voltage over a predetermined charge range of the corresponding charge cycle, and
- fit (204) the parameters of the model of the battery (150) based on the plurality of open circuit voltage curves, the parameters including electrode parameters that model a corresponding open circuit electrode potential for each electrode of the battery (150),

wherein the fitted parameters of the model comprise at least one charge cycle specific parameter ($C_{PE}$, $\sigma_{PE}$, $C_{NE}$, $\sigma_{NE}$, $C_{Li}$, $\gamma_{PE}$, $\gamma_{NE}$) that changes over lifetime of the battery, and at least one charge cycle unspecific parameter ($a_i$, $\Delta x_i$, $\Phi_{0,i}$, $a_j$, $\Delta x_j$, $\Phi_{0,j}$) that does not change over lifetime of the battery.

**Patentansprüche**

1. Computerimplementiertes Verfahren, umfassend

- Erfassen (202) einer Vielzahl von Leerlaufspannungskurven einer Batterie (150) bei einer Vielzahl vordefinierter Ladezyklen der Batterie, wobei jede der Leerlaufspannungskurven eine Leerlaufspannung über einen vorbestimmten Ladebereich des entsprechenden Ladezyklus angibt, und
- Anpassen (204) von Parametern eines Modells der Batterie basierend auf den mehreren Leerlaufspannungskurven, wobei die Parameter Elektrodenparameter beinhalten, die ein entsprechendes Leerlauf-Elektrodenpotential für jede Elektrode der Batterie modellieren,

wobei die angepassten Parameter des Modells mindestens einen ladungszyklusspezifischen Parameter (CPE, σPE, CNE, σNE, CLi, γPE, γNE), der sich über die Lebensdauer der Batterie hinweg ändert, sowie mindestens einen ladungszyklusunabhängigen Parameter (, Δxi, Φ0,i, , Δxj, Φ0,j), der sich über die Lebensdauer der Batterie hinweg nicht ändert, umfassen.

2. Verfahren nach Anspruch 1, wobei der vorgegebene Ladebereich mindestens entweder eine Vollladung mit einem vorgegebenen Ladestrom oder eine Vollentladung mit einem vorgegebenen Entladestrom umfasst.

3. Verfahren nach Anspruch 1 oder Anspruch 2, das ferner umfasst:

- Durchführen einer vordefinierten Anzahl äquivalenter Volllade- und Entladezyklen der Batterie zwischen dem Erhalten einer bestimmten Leerlaufspannungskurve aus der Vielzahl von Leerlaufspannungskurven und einer nachfolgenden Leerlaufspannungskurve aus der Vielzahl von Leerlaufspannungskurven.

4. Verfahren nach einem der vorstehenden Ansprüche,

wobei modellierte Leerlaufspannungskurven auf den modellierten Leerlaufelektrodenpotentialen basieren, wobei das Anpassen (204) der Parameter das Variieren zumindest einiger der Parameter des Modells umfasst, um mindestens eines der folgenden zu minimieren:

- eine erste Fehlersumme der Leerlaufspannungen einer der erhaltenen Leerlaufspannungskurven und der entsprechenden Leerlaufspannungen einer entsprechenden der modellierten Leerlaufspannungskurven;
- eine zweite Fehlersumme einer ersten diskreten Ableitung der Leerlaufspannungen in Bezug auf einen Ladezustand einer der erhaltenen Leerlaufspannungskurven und einer ersten diskreten Ableitung der entsprechenden Leerlaufspannungen in Bezug auf einen Ladezustand einer entsprechenden der modellierten Leerlaufspannungskurven;
- eine dritte Fehlersumme der Leerlaufspannungen aller ermittelten Leerlaufspannungskurven und der entsprechenden Leerlaufspannungen aller entsprechenden modellierten Leerlaufspannungskurven; und
- eine vierte Fehlersumme einer ersten diskreten Ableitung der Leerlaufspannungen in Bezug auf einen Ladezustand aller ermittelten Leerlaufspannungskurven und einer ersten diskreten Ableitung der entsprechenden Leerlaufspannungen in Bezug auf einen Ladezustand aller entsprechenden modellierten Leerlaufspannungskurven.

5. Verfahren nach Anspruch 4,

wobei die Parameter ladungszyklus-spezifische Parameter und ladungszyklusunspezifische Parameter umfassen, wobei die Anpassung (204) der Parameter Folgendes umfasst:

- für jeden der mehreren vordefinierten Ladezyklen: Variieren (804) der ladungszyklus-spezifischen Parameter, um die erste Summe, die zweite Summe oder eine Summe aus der ersten und der zweiten Summe zu minimieren, die sich auf die ermittelten und modellierten Leerlaufspannungskurven beziehen, welche dem Ladezyklus der ladungszyklus-spezifischen Parameter entsprechen, und
- Variieren (806) der ladungszyklus-unspezifischen Parameter, um die dritte Summe, die vierte Summe oder eine Summe aus der dritten und der vierten Summe zu minimieren.

6. Verfahren nach Anspruch 5, das ferner umfasst:

- nacheinander Durchführen der Variation der ladungszyklus-spezifischen Parameter und der Variation der ladungszyklus-unspezifischen Parameter sowie Wiederholen dieses nacheinander Durchführens für eine vorbestimmte Anzahl von Wiederholungen oder bis ein vordefiniertes Konvergenzkriterium für die Parameter erreicht ist.

7. Verfahren nach einem der vorstehenden Ansprüche, wobei die Parameter für jede Elektrode einen ladungszyklus-spezifischen Mittelwert und eine ladungszyklus-spezifische Standardabweichung umfassen, die sich auf die Kapazität der Elektrode im Modell beziehen.

8. Verfahren nach einem der vorstehenden Ansprüche, wobei die Parameter eine ladungszyklus-spezifische Kapazität an nutzbarem Lithium umfassen, das in der Batterie während des Ladens und Entladens der Batterie zyklierbar ist.

9. Verfahren nach einem der vorstehenden Ansprüche, wobei mindestens eine der Elektroden der Batterie eine Mischelektrode ist, die mindestens zwei nebeneinander vorkommende Elektrodenmaterialien umfasst, wobei die Parameter für jede Elektrode ein zyklusabhängiges Kapazitätsverhältnis zwischen den nebeneinander vorkommenden Materialien umfassen.

10. Verfahren nach einem der vorstehenden Ansprüche, wobei die Batterie eine Lithium-Ionen-Batterie ist, wobei die Lithiierung und/oder Delithiierung jeder Elektrode zu mehreren Phasenübergängen führt, wobei jedes Elektrodenmaterial eine vordefinierte Anzahl von Phasenübergängen aufweist, wobei die Parameter für jedes Elektrodenmaterial jeder Elektrode einen Näherungsparameter für die Wechselwirkungsenergie umfassen, der sich auf eine Wechselwirkungsenergie verschiedener Phasenübergänge bei der Lithiierung und/oder Delithiierung der Elektrodenmaterialien in der Elektrode bezieht.

11. Verfahren nach einem der vorstehenden Ansprüche, wobei die Batterie eine Lithium-Ionen-Batterie ist, wobei die Lithiierung und/oder Delithiierung jeder Elektrode zu mehreren Phasenübergängen führt, wobei jedes Elektrodenmaterial eine vordefinierte Anzahl von Phasenübergängen aufweist, wobei die Parameter für jeden Phasenübergang jedes Elektrodenmaterials jeder Elektrode einen gespeicherten relativen Ladungsparameter umfassen, der einen Anteil der durch den Phasenübergang gespeicherten Ladung im Verhältnis zur Kapazität der Elektrode angibt.

12. Verfahren nach einem der vorstehenden Ansprüche, wobei die Batterie eine Lithium-Ionen-Batterie ist, wobei die Lithiierung und/oder Delithiierung jeder Elektrode zu mehreren Phasenübergängen führt, wobei jedes Elektrodenmaterial eine vordefinierte Anzahl von Phasenübergängen aufweist, wobei die Parameter für jeden Phasenübergang jedes Elektrodenmaterials jeder Elektrode einen Gleichgewichtspotentialparameter umfassen, der ein Gleichgewichts-Elektrodenpotential des entsprechenden Phasenübergangs angibt.

13. Verfahren nach einem der vorstehenden Ansprüche, das ferner umfasst:

   - Parametrisieren (206) eines Alterungsmodells der Batterie basierend auf den angepassten Parametern, wobei das Alterungsmodell Batteriebelastungsfaktoren umfasst, und
   - Bestimmen (208) eines Gesundheitszustands für eine weitere Batterie desselben Typs wie die Batterie basierend auf dem Alterungsmodell und den während eines früheren Betriebs der weiteren Batterie ermittelten Belastungsfaktoren.

14. Vorrichtung zur Bestimmung von Parametern eines Batteriemodells, wobei die Vorrichtung mit einer steuerbaren Ladeschaltung (102) für die Batterie (150) und einer Messschaltung (104) koppelbar ist, die zur Messung einer Spannung an der Batterie (150) eingerichtet ist, wobei die Vorrichtung (100) umfasst:

   - eine Steuerschaltung (106), die so eingerichtet ist, dass sie:

      - die Ladeschaltung so steuert, dass diese eine Vielzahl vordefinierter Ladezyklen der Batterie (150) durchführt,
      - von der Messschaltung eine Vielzahl von Leerlaufspannungskurven der Batterie (150) bei der Vielzahl vordefinierter Ladezyklen der Batterie (150) erhält (202), wobei jede der Leerlaufspannungskurven eine Leerlaufspannung über einen vorbestimmten Ladebereich des entsprechenden Ladezyklus angibt, und
      - die Parameter des Modells der Batterie (150) basierend auf den mehreren Leerlaufspannungskurven anpasst (204), wobei die Parameter Elektrodenparameter umfassen, die ein entsprechendes Leerlauf-Elektrodenpotential für jede Elektrode der Batterie (150) modellieren,

   wobei die angepassten Parameter des Modells mindestens einen ladungszyklusspezifischen Parameter (CPE, $\sigma$PE, CNE, $\sigma$NE, CLi, $\gamma$PE, $\gamma$NE), der sich über die Lebensdauer der Batterie hinweg ändert, sowie mindestens einen ladungszyklusunabhängigen Parameter (, $\Delta$xi, $\Phi$0,i, , $\Delta$xj, $\Phi$0,j), der sich über die Lebensdauer der Batterie hinweg nicht ändert.

**Revendications**

1. Procédé mis en œuvre par ordinateur, comprenant

   - l'obtention (202) d'une pluralité de courbes de tension en circuit ouvert d'une batterie (150) à une pluralité de cycles de charge prédéfinis de la batterie, chacune des courbes de tension en circuit ouvert étant indicative d'une tension en circuit ouvert sur une plage de charge prédéterminée du cycle de charge correspondant, et
   - l'ajustement (204) de paramètres d'un modèle de la batterie sur la base de la pluralité de courbes de tension en circuit ouvert, les paramètres incluant des paramètres d'électrode qui modélisent un potentiel d'électrode en circuit ouvert correspondant pour chaque électrode de la batterie,

   dans lequel les paramètres ajustés du modèle comprennent au moins un paramètre spécifique au cycle de charge

($C_{PE}$, $\sigma_{PE}$, $C_{NE}$, $\sigma_{NE}$, $C_{Li}$, $\gamma_{PE}$, $\gamma_{NE}$) qui varie au cours de la durée de vie de la batterie, et au moins un paramètre non spécifique au cycle de charge ($a_i$, $\Delta x_i$, $\Phi_{0,i}$, $a_j$, $\Delta x_j$, $\Phi_{0,j}$) qui ne varie pas au cours de la durée de vie de la batterie.

2. Procédé selon la revendication 1, dans lequel la plage de charge prédéterminée couvre au moins l'une d'une charge totale avec un courant de charge prédéterminé ou d'une décharge totale à un courant de décharge prédéterminé.

3. Procédé selon la revendication 1 ou la revendication 2, comprenant en outre :

   - la réalisation, entre l'obtention d'une courbe de tension en circuit ouvert donnée de la pluralité de courbes de tension en circuit ouvert et d'une courbe de tension en circuit ouvert suivante de la pluralité de courbes de tension en circuit ouvert, d'un nombre prédéfini de cycles de charge et de décharge totale équivalents de la batterie.

4. Procédé selon l'une quelconque des revendications précédentes,

   dans lequel des courbes de tension en circuit ouvert modélisées sont basées sur les potentiels d'électrode en circuit ouvert modélisés,
   dans lequel ledit ajustement (204) des paramètres comprend la variation d'au moins certains des paramètres du modèle pour minimiser au moins l'un parmi :

   - une première somme d'erreurs des tensions en circuit ouvert de l'une des courbes de tension en circuit ouvert obtenues et de tensions en circuit ouvert correspondantes de l'une correspondante des courbes de tension en circuit ouvert modélisées ;
   - une deuxième somme d'erreurs d'une première dérivée discrète des tensions en circuit ouvert par rapport à un état de charge de l'une des courbes de tension en circuit ouvert obtenues et d'une première dérivée discrète de tensions en circuit ouvert correspondantes par rapport à un état de charge de l'une correspondante des courbes de tension en circuit ouvert modélisées ;
   - une troisième somme d'erreurs des tensions en circuit ouvert de toutes les courbes de tension en circuit ouvert obtenues et de tensions en circuit ouvert correspondantes de toutes les courbes de tension en circuit ouvert modélisées correspondantes ; et
   - une quatrième somme d'erreurs d'une première dérivée discrète des tensions en circuit ouvert par rapport à un état de charge de toutes les courbes de tension en circuit ouvert obtenues et d'une première dérivée discrète de tensions en circuit ouvert correspondantes par rapport à un état de charge de toutes les courbes de tension en circuit ouvert modélisées correspondantes.

5. Procédé selon la revendication 4,

   dans lequel les paramètres comprennent des paramètres spécifiques au cycle de charge et des paramètres non spécifiques au cycle de charge,
   dans lequel ledit ajustement (204) des paramètres comprend :

   - pour chacun de la pluralité de cycles de charge prédéfinis : la variation (804) des paramètres spécifiques au cycle de charge pour minimiser la première somme, la deuxième somme ou une somme de la première somme et de la deuxième somme se rapportant aux courbes de tension en circuit ouvert obtenues et modélisées correspondant au cycle de charge des paramètres spécifiques au cycle de charge, et
   - la variation (806) des paramètres non spécifiques au cycle de charge pour minimiser la troisième somme, la quatrième somme ou une somme de la troisième somme et de la quatrième somme.

6. Procédé selon la revendication 5, comprenant en outre :

   - la réalisation successive de ladite variation des paramètres spécifiques au cycle de charge et de ladite variation des paramètres non spécifiques au cycle de charge et la répétition de ladite réalisation successive pendant un nombre prédéterminé de répétitions ou jusqu'à ce qu'un critère de convergence prédéfini pour les paramètres soit atteint.

7. Procédé selon l'une quelconque des revendications précédentes,
   dans lequel les paramètres comprennent pour chaque électrode une valeur moyenne spécifique au cycle de charge et un écart-type spécifique au cycle de charge qui se rapportent à la capacité de l'électrode dans le modèle.

8. Procédé selon l'une quelconque des revendications précédentes,
dans lequel les paramètres comprennent une capacité spécifique au cycle de charge de lithium utilisable qui est cyclable dans la batterie pendant la charge et la décharge de la batterie.

9. Procédé selon l'une quelconque des revendications précédentes,

dans lequel au moins l'une des électrodes de la batterie est une électrode de mélange comprenant au moins deux matériaux d'électrode coexistants,
dans lequel les paramètres comprennent pour chaque électrode un rapport de capacité spécifique au cycle de charge entre les matériaux coexistants.

10. Procédé selon l'une quelconque des revendications précédentes,
dans lequel la batterie est une batterie lithium-ion, dans lequel la lithiation et/ou la délithiation de chaque électrode résulte en de multiples transitions de phase, dans lequel chaque matériau d'électrode a un nombre prédéfini de transitions de phase, dans lequel les paramètres comprennent pour chaque matériau d'électrode de chaque électrode un paramètre d'approximation d'énergie d'interaction relatif à une énergie d'interaction de différentes transitions de phase de lithiation et/ou de délithiation des matériaux d'électrode dans l'électrode.

11. Procédé selon l'une quelconque des revendications précédentes,
dans lequel la batterie est une batterie lithium-ion, dans lequel la lithiation et/ou la délithiation de chaque électrode résulte en de multiples transitions de phase, dans lequel chaque matériau d'électrode a un nombre prédéfini de transitions de phase, dans lequel les paramètres comprennent pour chaque transition de phase de chaque matériau d'électrode de chaque électrode un paramètre de charge relative stockée indiquant une fraction de charge stockée par la transition de phase par rapport à la capacité de l'électrode.

12. Procédé selon l'une quelconque des revendications précédentes,
dans lequel la batterie est une batterie lithium-ion, dans lequel la lithiation et/ou la délithiation de chaque électrode résulte en de multiples transitions de phase, dans lequel chaque matériau d'électrode a un nombre prédéfini de transitions de phase, dans lequel les paramètres comprennent pour chaque transition de phase de chaque matériau d'électrode de chaque électrode un paramètre de potentiel d'équilibre indiquant un potentiel d'électrode d'équilibre de la transition de phase correspondante.

13. Procédé selon l'une quelconque des revendications précédentes, comprenant en outre :

- le paramétrage (206) d'un modèle de vieillissement de la batterie sur la base des paramètres ajustés, le modèle de vieillissement incluant des facteurs de contrainte de batterie, et
- la détermination (208) pour une autre batterie ayant le même type que la batterie d'un état de santé sur la base du modèle de vieillissement et des facteurs de contrainte obtenus pendant un fonctionnement précédent de l'autre batterie.

14. Dispositif pour déterminer des paramètres d'un modèle d'une batterie, dans lequel le dispositif peut être couplé à un circuit de charge pouvant être commandé (102) pour la batterie (150) et un circuit de mesure (104) configuré pour mesurer une tension au niveau de la batterie (150), dans lequel le dispositif (100) comprend :

- un circuit de commande (106) configuré pour :

- commander le circuit de charge pour réaliser une pluralité de cycles de charge prédéfinis de la batterie (150),
- obtenir (202), à partir du circuit de mesure, une pluralité de courbes de tension en circuit ouvert de la batterie (150) à la pluralité de cycles de charge prédéfinis de la batterie (150), chacune des courbes de tension en circuit ouvert étant indicative d'une tension en circuit ouvert sur une plage de charge prédéterminée du cycle de charge correspondant, et
- ajuster (204) les paramètres du modèle de la batterie (150) sur la base de la pluralité de courbes de tension en circuit ouvert, les paramètres incluant des paramètres d'électrode qui modélisent un potentiel d'électrode en circuit ouvert correspondant pour chaque électrode de la batterie (150),

dans lequel les paramètres ajustés du modèle comprennent au moins un paramètre spécifique au cycle de charge ($C_{PE}$, $\sigma_{PE}$, $C_{NE}$, $\sigma_{NE}$, $C_{Li}$, $\gamma_{PE}$, $\gamma_{NE}$) qui varie au cours de la durée de vie de la batterie, et au moins un paramètre non spécifique au cycle de charge ($a_i$, $\Delta x_i$, $\Phi_{0,i}$, $a_j$, $\Delta x_j$, $\Phi_{0,j}$) qui ne varie pas au cours de la durée de vie de la batterie.

## Fig. 1

## Fig. 2

| | |
|---|---|
| Obtaining a plurality of OCV curves of a battery | 202 |
| Fitting model parameters based on the OCV curves | 204 |
| Parameterizing an aging model based on the fitted parameters | 206 |
| Determining for a further battery a state of health based on the aging model | 208 |

## Fig. 3

## Fig. 4

## Fig. 5

**Fig. 6**

**Fig. 7**

## Fig. 8

800

```
┌─────────────────────────────────────────────┐
│ Determine initial values for charge cycle    │ ── 802
│ unspecific and charge cycle specific         │
│ parameters                                    │
└─────────────────────────────────────────────┘
                      │
                      ▼
┌─────────────────────────────────────────────┐
│ Optimize charge cycle specific parameters for│ ── 804
│ each checkup phase separately                 │
└─────────────────────────────────────────────┘
                      │
                      ▼
┌─────────────────────────────────────────────┐
│ Optimize charge cycle unspecific parameters  │ ── 806
│ on all checkup phases simultaneously          │
└─────────────────────────────────────────────┘
                      │
                      ▼
              Stop or convergence    ── 808
                 criteria met?
```

## Fig. 9

# Fig. 10

a)

b)

c)

## Fig. 11

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2021359347 A1

**Non-patent literature cited in the description**

- **CHEN CHANG-HUI et al.** Development of Experimental Techniques for Parameterization of Muli-scale Lithium-ion Battery Models. *Journal of the Electrochemical Society*, 15 May 2020, vol. 167
- **Y ANDREW WENG et al.** Differential Volage Analysis for Battery Manufacturing Process Control. *arxiv.org*, 13 March 2023
- **A. A. WANG** ; **S. E. O'KANE** ; **F. BROSA PLANELLA** ; **J. L. HOUX** ; **K. O'REGAN** ; **M. ZYSKIN** ; **J. EDGE** ; **C. W. MONROE** ; **S. J. COOPER** ; **D. A. HOWEY**. Review of parameterisation and a novel database (LiionDB) for continuum Li-ion battery models. *Prog. Energy*, 2022, vol. 4
- **C.-H. CHEN** ; **F. BROSA PLANELLA** ; **K. O'REGAN** ; **D. GASTOL** ; **W. D. WIDANAGE** ; **E. KENDRICK**. Development of Experimental Techniques for Parameterization of Multi-scale Lithium-ion Battery Models. *J. Electrochem. Soc.*, 2020, vol. 167, 080534
- **O. CHAOUACHI** ; **J. M. RETY** ; **S. G ' ENIES** ; **M. CHANDESRIS** ; **Y. BULTEL**. Experimental and theoretical investigation of Li-ion battery active materials properties: Application to a graphite/-Ni0.6Mn0.2Co0.2O2 system. *Electrochim. Acta*, 2021, vol. 366, 137428
- **K. KITADA** ; **O. PECHER** ; **P. C. MAGUSIN** ; **M. F. GROH** ; **R. S. WEATHERUP** ; **C. P. GREY**. Unraveling the Reaction Mechanisms of SiO Anodes for Li-Ion Batteries by Combining in Situ 7Li and ex Situ 7Li/29Si SolidState NMR Spectroscopy. *J. Am. Chem. Soc.*, 2019, vol. 141, 7014-7027